# EUROPÄISCHE PATENTANMELDUNG

(11) **EP 0 742 644 A2**
(43) Veröffentlichungstag der Anmeldung: **13.11.1996**
(21) Anmeldenummer: 96106903.6
(22) Anmeldetag: 02.05.1996
(51) Int. Cl.: H03H 9/64

(54) **Resonatorfilter**

(30) Priorität: 09.05.1995 DE 19516903
(71) Anmelder: TELE FILTER tft GmbH, D-14513 Teltow (DE)
(72) Erfinder: Martin,Günter Dr., 01307 Dresden (DE); Weihnacht,Manfred Dr., 01744 Malter-Paulsdorf (DE)
(74) Vertreter: Rauschenbach, Dieter

(57) **Zusammenfassung**

Der Erfindung liegt die Aufgabe zugrunde, Resonatorfilter, bei denen auf einem piezoelektrischen Substrat ein linker und ein rechter Streifenreflektor und zwei interdigitale Wandler, die als Sender bzw. Empfänger betrieben werden, so angeordnet sind, daß die Streifenreflektoren einen ebenen Hohlraum einschließen, derart zu verändern, daß die Bandbreite des Filters größer ist als die Summe der Frequenzabstände der jeweiligen Resonanzen der nieder- und hochfrequenten Resonanzgruppe.

Das erfindungsgemäße Resonatorfilter ist dadurch gekennzeichnet, daß
a) Sender und Empfänger, bezeichnet als Wandlergruppe, in Richtung der Wandlerzinken nebeneinander angeordnet sind,
b) Sender und Empfänger bezüglich der parallel zu den Metallstreifen der Streifenreflektoren gerichteten Mittellinie des Hohlraumes unsymmetrisch angeordnet und/oder aufgebaut sind
   und
c) Sender und Empfänger aus jeweils zwei Teilwandlern zusammengesetzt sind, die senkrecht zu den Wandlerzinken hintereinander angeordnet sind und den Zwischenraum Z_{TW} einschließen.

Die Erfindung ist anwendbar bei Bauelementen auf der Basis akustischer Oberflächenwellen, wie schmalbandigen Bandpaßfiltern und Oszillatoren.

## Beschreibung

Die Erfindung bezieht sich auf das Gebiet Elektrotechnik/ Elektronik. Objekte, bei denen die Anwendung möglich und zweckmäßig ist, sind Bauelemente auf der Basis akustischer Oberflächenwellen, wie schmalbandige Bandpaßfilter und Oszillatoren.

Es sind Resonatorfilter bekannt, bei denen auf einem piezoelektrischen Substrat ein linker und ein rechter Streifenreflektor und zwei interdigitale Wandler, die als Sender bzw. Empfänger betrieben werden, so angeordnet sind, daß die Streifenreflektoren einen ebenen Hohlraum einschließen. In dem Hohlraum befinden sich die interdigitalen Wandler, wobei die Zinkenüberlappungsgebiete des Senders und Empfängers verschiedene Hohlraumhälften, unterteilt durch die senkrecht zu den Streifen der Streifenreflektoren und zu den Wandlerzinken verlaufende Mittellinie, besetzen. Außerdem bilden Streifenreflektoren und interdigitale Wandler in Richtung dieser Mittellinie einen Wellenleiter für akustische Oberflächenwellen.

Bei einer speziellen Ausführung ("SAW Composite Longitudinal Mode Resonator (CLMR) Filters and Their Application to New Synthesized Resonator Filters", 1993 IEEE Ultrasonics Symposium Proceedings, S. 47-51) sind Sender und Empfänger im Hohlraum senkrecht zu den Wandlerzinken hintereinander angeordnet. Die Breite des Streifen-/Zinkengebietes und die Metallschichtdicke sind so gewählt, daß zwei Wellenleitermoden existieren. Die Wandleranordnung im Hohlraum gestattet, zwei benachbarte Hohlraumresonanzen gleich stark anzuregen und zu empfangen. Jede dieser Hohlraumresonanzen trifft infolge der Existenz von zwei Wellenleitermoden verdoppelt auf, so daß eine nieder- bzw. hochfrequente Resonanzgruppe, die der nieder- bzw. hochfrequenten Hohlraumresonanz zuzuordnen ist und aus je zwei Resonanzen besteht, unterschieden werden kann. Die Parameter, die die Frequenz dieser Resonanzen bestimmen, sind so gewählt, daß die Frequenz der hochfrequenten Resonanz der niederfrequenten Resonanzgruppe mit der Frequenz der niederfrequenten Resonanz der hochfrequenten Resonanzgruppe übereinstimmt.

Diese Lösung hat den Nachteil, daß die Bandbreite des Filters, die im wesentlichen durch den Frequenzabstand der voneinander am weitesten entfernten Resonanzen bestimmt wird, nicht größer ist als die Summe der Frequenzabstände der jeweiligen Resonanzen der nieder- und hochfrequenten Resonanzgruppe. Die der bekannten Lösung zugrundeliegende Anordnung ist nicht geeignet, die Bandbreite zu vergrößern durch Realisierung des Falles, daß die Frequenz der hochfrequenten Resonanz der niederfrequenten Resonanzgruppe kleiner ist, als die Frequenz der niederfrequenten Resonanz der hochfrequenten Resonanzgruppe. Der Grund besteht darin, daß in diesem Fall ein tiefer Einschnitt im Paßband des Filters entsteht, der nicht oder nicht ohne inakzeptable Deformation des Paßbandes durch äußere Anpaßnetzwerke beseitigt werden kann.

Der Erfindung liegt die Aufgabe zugrunde, Resonatorfilter der bekannten Art so zu verändern, daß die Bandbreite des Filters größer ist als die Summe der Frequenzabstände der jeweiligen Resonanzen der nieder- und hochfrequenten Resonanzgruppe.

Diese Aufgabe ist mit dem in den Patentansprüchen beschriebenen Resonatorfilter gelöst.

Hierbei sind bei einem Resonatorfilter der eingangs beschriebenen Gattung erfindungsgemäß
a) Sender und Empfänger, bezeichnet als Wandlergruppe, in Richtung der Wandlerzinken nebeneinander angeordnet,
b) Sender und Empfänger bezüglich der parallel zu den Metallstreifen der Streifenreflektoren gerichteten Mittellinie des Hohlraumes unsymmetrisch angeordnet und/oder aufgebaut
   und
c) Sender und Empfänger aus jeweils zwei Teilwandlern zusammengesetzt, die senkrecht zu den Wandlerzinken hintereinander angeordnet sind und den Zwischenraum Z_{TW} einschließen.

Nach einer zweckmäßigen Ausgestaltung der Erfindung ist im Hohlraum in Richtung senkrecht zu den Wandlerzinken neben der Wandlergruppe ein Streifengitter, bestehend aus N Metallstreifen, so angeordnet, daß die Metallstreifen parallel zu den Wandlerzinken sind und ihr Abstand sich vom Streifenabstand der Reflektoren unterscheidet, wobei die Wandlergruppe den Zwischenraum Z_{LRW} bzw. Z_{WRR} zum linken bzw. rechten Reflektor bildet.

Nach einer weiteren zweckmäßigen Ausgestaltung der Erfindung sind die Überlappungslängen von Sender und Empfänger durch Wichtungsfaktoren so gewählt, daß bezüglich der zu den Wandlerzinken parallelen Mittellinien der Wandler die Verteilung der Überlappungslängen unsymmetrisch ist, wobei negative Wichtungsfaktoren durch Umpolung der Zinken, die die jeweilige Überlappungslänge bilden, gegenüber den Überlappungslängen mit positivem Wichtungsfaktor realisiert sind.

Weiterhin ist es zweckmäßig, wenn Sender und Empfänger gleiche Zinkenanordnungen haben.

Die Anzahl N der Metallstreifen des Streifengitters kann gleich null sein. Es ist zweckmäßig, wenn die Zwischenräume Z_{LRW} und Z_{WRR} nicht übereinstimmen. Die Summe der Zwischenräume kann ein ungeradzahliges Vielfaches der halben Wandlerperiodenlänge sein. Beide Teilwandler jedes interdigitalen Wandlers können gleich viele Zinken haben.

Wenn eine unsymmetrische Überlappungslängenverteilung durch Umpolen eines Bruchteils der Wandlerzinken realisiert wird, so ist es besonders zweckmäßig, diesen Bruchteil wesentlich von 1/2 abweichen zu lassen.

Es ist auch besonders zweckmaßig, dem Zwischenraum Z_{TW} ungleich einem Viertel der Wandlerperiodenlänge zu wählen.

Die Summe der Zwischenräume aus Z_{LRW} und Z_{WRR} kann gleich einer halben Wandlerperiodenlänge und Z_{LRW} oder Z_{WRR} kann kleiner als ein Viertel der Wandlerperiodenlänge sein.

Zweckmäßig ist es auch, die Breite des Streifen-/Zinkengebiets und die Dicke der Metallschicht, aus der die interdigitalen Wandler und die Reflektoren bestehen, so zu wählen, daß mindestens zwei Wellenleitermoden existieren.

Besonders zweckmäßig ist es, wenn der Bruchteil der umgepolten Zinken zwischen 1/4 und 1/3 liegt und der Zwischenraum Z_{TW} kleiner ist als ein Viertel der Wandlerperiodenlänge. Die Wandlergruppe kann den Hohlraum zu 50 bis 60% ausfüllen. Die Anzahl der umgepolten Zinken kann gleich null und gleichzeitig der Zwischenraum Z_{TW} kleiner sein als ein Viertel der Wandlerperiodenlänge. Zur Einstellung einer großen Bandbreite ist es zweckmäßig, wenn die Hohlraumlänge und die Metallschichtdicke so gewählt sind, daß die Frequenzdifferenz derjenigen Resonanzen, die von ein und derselben Wellenleitermode verursacht werden und die zu benachbarten Hohlraumresonanzen gehören, größer ist als die Frequenzdifferenz derjenigen Resonanzen, die durch benachbarte Wellenleitermoden verursacht werden und zu ein und derselben Hohlraumresonanz gehören.

Mehrere Resonatorfilter können eine Filterkaskade bilden, wobei der Empfänger eines der Filter an den Sender des nachfolgenden Filters über elektrische Verbindungen angeschlossen ist. Zwischen diese elektrischen Verbindungen kann eine Induktivität geschaltet sein.

Die Erfindung ist nachstehend anhand eines Ausführungsbeispiels und einer zugehörigen Zeichnung näher erläutert.

Das Beispiel betrifft ein Resonatorfilter, bei dem auf einem piezoelektrischen Substrat 1 ein linker bzw. rechter Streifenreflektor 2 bzw. 3 mit Metallstreifen 21 bzw. 31 so angeordnet ist, daß die Streifenreflektoren einen ebenen Hohlraum 4 einschließen. Im Hohlraum 4 sind interdigitale Wandler 5 und 6 so nebeneinander angeordnet, daß deren Zinkenüberlappungsgebiete verschiedenen Hohlraumhälften, unterteilt durch die senkrecht zu den Streifen 21 bzw. 31 der Streifenreflektoren 2 bzw. 3 und zu den Wandlerzinken verlaufende Mittellinie 41, besetzen.

Beide interdigitalen Wandler 5 bzw. 6, die den Eingang 11 bzw. Ausgang 12 bilden und deshalb als Sender bzw. Empfänger betrieben werden, sind vollkommen identisch und symmetrisch zur Mittellinie 41 aufgebaut. Zwischen dem Sender 5 bzw. dem Empfänger 6 und dem linken Reflektor 2 ist ein Zwischenraum 7 bzw. 9 vorhanden. Die Zwischenräume 7 und 9 sind gleich und betragen 0,29p_{W} (p_{W} = Periodenlänge der Wandler). Sender 5 bzw. Empfänger 6 bilden mit dem rechten Reflektor 3 einen Zwischenraum 8 bzw. 10. Beide Zwischenräume 8 und 10 sind gleich und betragen 0,21p_{W}.

Sowohl Sender 5 als auch Empfänger 6 bestehen aus Teilwandlern 51 und 52 bzw. 61 und 62 mit den Zinken 511 und 521 bzw. 611 und 621, die einen Zwischenraum 53 bzw. 63 einschließen. Die Breite der Zwischenräume 53 und 63 beträgt 0,15p_{W}.

Sender 5 bzw. Empfänger 6 sind bezüglich der Mittellinie 55 dadurch unsymmetrisch aufgebaut, daß der Teil 54 bzw. 64 der Wandlerzinken gegenüber den übrigen umgepolt ist. Bei einer Zinkenanzahl von 920 je Wandler sind jeweils 278 umgepolt. Jeder der Teilwandler 51, 52, 61 und 62 enthält 460 Zinken. Der Zinkenabstand in den Wandlern 5 und 6 beträgt das 0,9985-fache des Streifenabstands der Streifenreflektoren 2 und 3.

Die Metallstreifen der Streifenreflektoren sind 8,0p_{W} lang und der zentrale Steg 56, der an Masse 13 angeschlossen ist, ist 2,4p_{W} breit.

Die gesamte Struktur besteht aus einer Aluminiumschicht mit einer Dicke von 0,011p_{W}.

Die gewählten Werte für die Länge der Metallstreifen 21, 31, die Breite des zentralen Steges 56 und die Aluminiumschichtdicke gewährleisten die Existenz der zwei langsamsten Wellenleitermoden, wenn das Substrat 1 aus ST-Quarz besteht und die Richtung senkrecht zu den Wandlerzinken parallel zur X-Achse von Quarz ist.

Die vorliegende Länge des Hohlraumes 4, die sich aus der Länge der Wandler 5 bzw. 6 und den Zwischenräumen 7 und 8 bzw. 9 und 10 zusammensetzt, die Breiten der Zwischenräume 7 und 8 bzw. 9 und 10 sowie die Breite des Zwischenraumes 53 bzw. 63 garantieren, daß jede Wellenleitermode zwei Hohlraumresonanzen mit etwa gleichem Pegel erzeugt, wobei der Frequenzabstand dieser Hohlraumresonanzen etwa doppelt so groß ist wie der Frequenzabstand von zwei Hohlraumresonanzen, die von ein und derselben Wellenleitermode erzeugt werden.

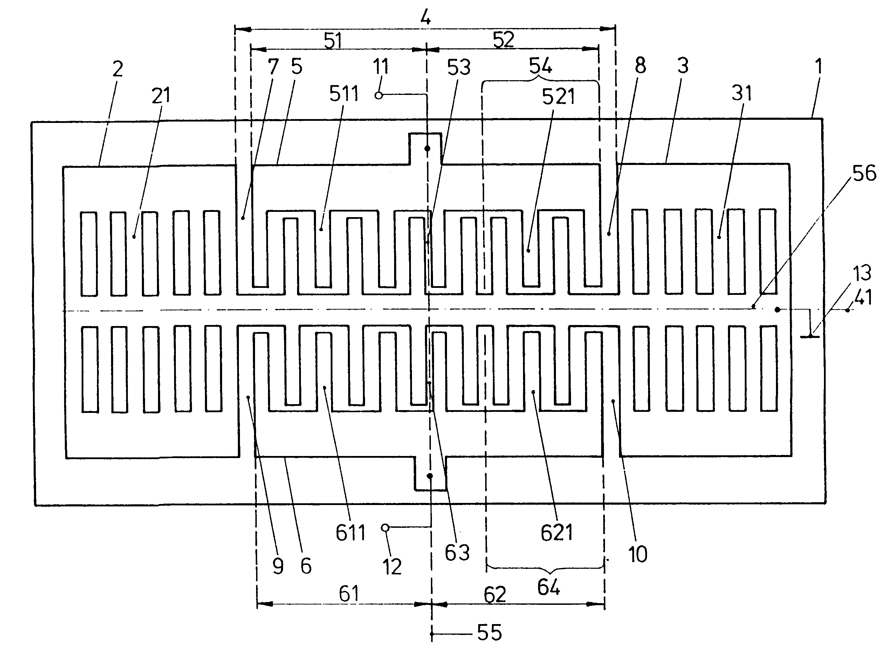

## Patentansprüche

1. Resonatorfilter, bei dem auf einem piezoelektrischen Substrat ein linker und ein rechter Streifenreflektor und zwei interdigitale Wandler, die als Sender bzw. Empfänger betrieben werden, so angeordnet sind, daß die Streifenreflektoren einen ebenen Hohlraum einschließen, in dem sich die interdigitalen Wandler befinden, wobei die Zinkenüberlappungsgebiete des Senders und Empfängers verschiedene Hohlraumhälften, unterteilt durch die senkrecht zu den Streifen der Streifenreflektoren und zu den Wandlerzinken verlaufende Mittellinie, besetzen, und wobei Streifenreflektoren und interdigitale Wandler in Richtung dieser Mittellinie einen Wellenleiter für akustische Oberflächenwellen bilden, **dadurch gekennzeichnet**, daß
a) Sender und Empfänger, bezeichnet als Wandlergruppe, in Richtung der Wandlerzinken nebeneinander angeordnet sind,
b) Sender und Empfänger bezüglich der parallel zu den Metallstreifen der Streifenreflektoren gerichteten Mittellinie des Hohlraumes unsymmetrisch angeordnet und/oder aufgebaut sind
und
c) Sender und Empfänger aus jeweils zwei Teilwandlern zusammengesetzt sind, die senkrecht zu den Wandlerzinken hintereinander angeordnet sind und den Zwischenraum Z_{TW} einschließen.

2. Resonatorfilter nach Anspruch 1, **dadurch gekennzeichnet**, daß im Hohlraum in Richtung senkrecht zu den Wandlerzinken neben der Wandlergruppe ein Streifengitter, bestehend aus N Metallstreifen, so angeordnet ist, daß die Metallstreifen parallel zu den Wandlerzinken sind und ihr Abstand sich vom Streifenabstand der Reflektoren unterscheidet, wobei die Wandlergruppe den Zwischenraum Z_{LRW} bzw. Z_{WRR} zum linken bzw. rechten Reflektor bildet.

3. Resonatorfilter nach Anspruch 1, **dadurch gekennzeichnet**, daß die Überlappungslängen von Sender und Empfänger durch Wichtungsfaktoren so gewählt sind, daß bezüglich der zu den Wandlerzinken parallelen Mittellinien der Wandler die Verteilung der Überlappungslängen unsymmetrisch ist, wobei negative Wichtungsfaktoren durch Umpolung der Zinken, die die jeweilige Überlappungslänge bilden, gegenüber den Überlappungslängen mit positivem Wichtungsfaktor realisiert sind.

4. Resonatorfilter nach Anspruch 1, **dadurch gekennzeichnet**, daß Sender und Empfänger gleiche Zinkenanordnungen haben.

5. Resonatorfilter nach Anspruch 4, **dadurch gekennzeichnet**, daß die Anzahl der Metallstreifen N des Streifengitters gleich null ist.

6. Resonatorfilter nach Anspruch 4, **dadurch gekennzeichnet**, daß die Zwischenräume Z_{LRW} und Z_{WRR} unterschiedlich groß sind.

7. Resonatorfilter nach Anspruch 2, **dadurch gekennzeichnet**, daß die Summe aus Z_{LRW} und Z_{WRR} ein ungeradzahliges Vielfaches der halben Wandlerperiodenlänge ist.

8. Resonatorfilter nach Anspruch 1, **dadurch gekennzeichnet**, daß beide Teilwandler jedes interdigitalen Wandlers gleich viele Zinken haben.

9. Resonatorfilter nach Anspruch 3, **dadurch gekennzeichnet**, daß ein Bruchteil der Zinken jedes interdigitalen Wandlers, der wesentlich von 1/2 abweicht, umgepolt ist.

10. Resonatorfilter nach Anspruch 1, **dadurch gekennzeichnet**, daß der Zwischenraum Z_{TW} ungleich einem Viertel der Wandlerperiodenlänge ist.

11. Resonatorfilter nach Anspruch 5 und 7, **dadurch gekennzeichnet**, daß die Summe aus Z_{LRW} und Z_{WRR} gleich einer halben Wandlerperiodenlänge und Z_{LRW} oder Z_{WRR} kleiner als ein Viertel der Wandlerperiodenlänge ist.

12. Resonatorfilter nach Anspruch 1, **dadurch gekennzeichnet**, daß die Breite des Streifen-/Zinkengebietes und die Dicke der Metallschicht, aus der die interdigitalen Wandler und die Reflektoren bestehen, so gewählt sind, daß mindestens zwei Wellenleitermoden existieren.

13. Resonatorfilter nach Anspruch 4, 5 und 8 bis 12, **dadurch gekennzeichnet**, daß der Bruchteil der umgepolten Zinken zwischen 1/4 und 1/3 liegt und der Zwischenraum Z_{TW} kleiner ist als ein Viertel der Wandlerperiodenlänge.

14. Resonatorfilter nach Anspruch 2, 4, 8, 10 und 12, **dadurch gekennzeichnet**, daß die Wandlergruppe den Hohlraum zu 50 bis 60 % ausfüllt.

15. Resonatorfilter nach Anspruch 4 bis 6 und 8 bis 10, **dadurch gekennzeichnet**, daß die Anzahl der umgepolten Zinken gleich null und der Zwischenraum Z_{TW} kleiner als ein Viertel der Wandlerperiodenlänge ist.

16. Resonatorfilter nach Anspruch 13 oder 14, **dadurch gekennzeichnet**, daß die Hohlraumlänge und die Metallschichtdicke so gewählt sind, daß die Frequenzdifferenz derjenigen Resonanzen, die von ein und derselben Wellenleitermode verursacht werden und zu benachbarten Hohlraumresonanzen gehören, größer ist als die Frequenzdifferenz derjenigen Resonanzen, die durch benachbarte Wellenleitermoden verursacht werden und zu ein und derselben Hohlraumresonanz gehören.

17. Resonatorfilter nach Anspruch 1, **dadurch gekennzeichnet**, daß mehrere Resonatorfilter eine Filterkaskade bilden, wobei der Empfänger eines der Filter an den Sender des nachfolgenden Filters über elektrische Verbindungen angeschlossen ist.

18. Resonatorfilter nach Anspruch 17, **dadurch gekennzeichnet**, daß zwischen die elektrischen Verbindungen zwei aufeinanderfolgender Filter eine Induktivität geschaltet ist.
